# EUROPEAN PATENT APPLICATION

(11) **EP 2 426 672 A1**
(43) Date of publication of application: **07.03.2012**
(21) Application number: 10769665.0
(22) Date of filing: 22.04.2010
(51) Int. Cl.: H01B 5/16, H01B 5/00, H01R 11/01

(54) **ANISOTROPIC CONDUCTIVE PARTICLES**

(30) Priority: 28.04.2009 JP 2009109101
(71) Applicant: Hitachi Chemical Company, Ltd., Tokyo 163-0449 (JP)
(72) Inventor: ARIFUKU Motohiro, Chikusei-shi Ibaraki 308-8524 (JP); KOBAYASHI Kouji, Chikusei-shi Ibaraki 308-8524 (JP); FUJINAWA Tohru, Chikusei-shi Ibaraki 308-8524 (JP)
(74) Representative: Siegert, Georg
(86) International application number: PCT/JP2010/057166
(87) International publication number: WO 2010/125966

(57) **Abstract**

The anisotropic conductive particles of the invention have conductive fine particles 2 dispersed in an organic insulating material 3.

## Description

### Technical Field

The present invention relates to anisotropic conductive particles.

### Background Art

Particles with conductivity are combined with binder resins, for example, and used as circuit connecting materials in electronic products such as semiconductor elements and liquid crystal displays for electrical connection of circuit electrodes.

As densification of circuit electrodes continues to advance with downsizing and reduced thicknesses of electronic products in recent years, circuit spacings and circuit widths have become extremely small.

The circuit connecting materials there have conventionally been used include anisotropic conductive adhesives dispersing, as conductive particles, nickel particles in an organic insulating adhesive or metal-plated resin particles having nickel or gold plated on plastic particle surfaces. However, when such circuit connecting materials are used for conjugation in high-density circuits, the conductive particles often form links between adjacent circuits, causing shorting.

Measures proposed as solutions to this problem include coating an insulating resin on the conductive particle surfaces (see Patent document 1), and immobilizing insulating fine particles on the conductive particle surfaces (see Patent document 2).

### [Citation List]

### [Patent literature]

[Patent document 1] Japanese Patent Publication No. 2546262
[Patent document 2] Japanese Unexamined Patent Application Publication No. 2007-258141

### Summary of Invention

### Technical Problem

Even with the conductive particles described in Patent documents 1 and 2, however, friction between adjacent conductive particles during circuit connection can result in flaking off of the insulating resin coating on the conductive particle surface or the insulating fine particles immobilized on the conductive particles, thus exposing the metal on the particle surfaces and creating shorts.

It is an object of the present invention, which has been accomplished in light of the aforementioned problems of the prior art, to provide anisotropic conductive particles which, when used as a circuit connecting material, can both ensure insulation between adjacent circuits and ensure conductivity between opposing circuits.

### Solution to Problem

In order to achieve the object stated above, the invention provides anisotropic conductive particles having conductive fine particles dispersed in an organic insulating material. Because the anisotropic conductive particles have conductive fine particles dispersed in an organic insulating material, when they are used in a circuit connecting material they can help prevent flaking off of the organic insulating material by friction between adjacent anisotropic conductive particles during circuit connection, while also adequately limiting creation of shorts. The anisotropic conductive particles also undergo deformation by pressure during circuit connection, thus allowing conductivity to be obtained between opposing circuits through the conductive fine particles. When used in a circuit connecting material, therefore, the anisotropic conductive particles can both ensure insulation between adjacent circuits and ensure conductivity between opposing circuits.

The invention further provides anisotropic conductive particles wherein the resistance after 50% flattening from the particle diameter, upon application of pressure to the anisotropic conductive particles, is no greater than 1/100 of the resistance of the anisotropic conductive particles before application of pressure. When used in a circuit connecting material, such anisotropic conductive particles that satisfy the aforementioned condition can both ensure insulation between adjacent circuits and ensure conductivity between opposing circuits.

The anisotropic conductive particles preferably comprise conductive fine particles dispersed in an organic insulating material. Because the anisotropic conductive particles have conductive fine particles dispersed in an organic insulating material, when they are used in a circuit connecting material they can help prevent flaking off of the organic insulating material by friction between adjacent anisotropic conductive particles during circuit connection, while also adequately limiting occurrence of shorts. The anisotropic conductive particles also undergo deformation by pressure during circuit connection, thus allowing conductivity to be obtained between opposing circuits through the conductive fine particles. When used in a circuit connecting material, therefore, the anisotropic conductive particles can both ensure insulation between adjacent circuits and ensure conductivity between opposing circuits.

The anisotropic conductive particles of the invention preferably comprise 20-300 parts by volume of the conductive fine particles dispersed in 100 parts by volume of the organic insulating material. When used in a circuit connecting material, the anisotropic conductive particles having such a structure can more adequately both ensure insulation between adjacent circuits and ensure conductivity between opposing circuits.

The mean particle size of the conductive fine particles in the anisotropic conductive particles of the invention is preferably 0.0002-0.6 times the mean particle size of the anisotropic conductive particles. When used in a circuit connecting material, the anisotropic conductive particles having such a structure can more adequately both ensure insulation between adjacent circuits and ensure conductivity between opposing circuits.

The maximum particle size of the conductive fine particles in the anisotropic conductive particles of the invention is preferably no greater than 0.9 times the mean particle size of the anisotropic conductive particles. When used in a circuit connecting material, the anisotropic conductive particles having such a structure can more adequately ensure insulation between adjacent circuits.

The conductive fine particles in the anisotropic conductive particles of the invention are preferably particles composed of a carbon material. The carbon material is preferably graphite or carbon nanotubes. When used in a circuit connecting material, the anisotropic conductive particles having such a structure can more adequately both ensure insulation between adjacent circuits and ensure conductivity between opposing circuits.

The conductive fine particles in the anisotropic conductive particles of the invention are preferably particles composed of a metal material, the metal material preferably being silver or gold. Particles composed of these metal materials are preferred because they have low resistivity and allow sufficiently low connection resistance to be obtained with small amounts.

The shapes of the conductive fine particles in the anisotropic conductive particles of the invention are preferably scaly or needle-like. Conductive fine particles with scaly or needle-like shapes have greater surface area for the same volume, compared to spherical particles, elliptical particles or globular particles, and are therefore preferred for obtaining sufficiently low connection resistance in smaller usage amounts.

The conductive fine particles in the anisotropic conductive particles of the invention preferably have hydrophobic-treated surfaces. Hydrophobic treatment of the conductive fine particle surfaces is preferred as it can increase the bonding strength between the conductive fine particles and the organic insulating material of the anisotropic conductive particles.

The anisotropic conductive particles of the invention preferably have a mean particle size of 0.5-30 µm. When used in a circuit connecting material, the anisotropic conductive particles having such a structure can more adequately both ensure insulation between adjacent circuits and ensure conductivity between opposing circuits.

### Advantageous Effects of Invention

According to the invention, it is possible to provide anisotropic conductive particles that, when used in a circuit connecting material, can both ensure insulation between adjacent circuits and ensure conductivity between opposing circuits.

### Brief Description of Drawings

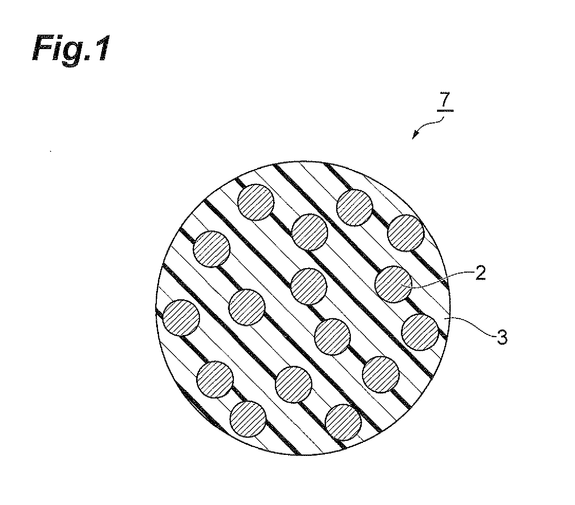

Fig. 1 is a schematic cross-sectional view showing a preferred embodiment of anisotropic conductive particles of the invention.

### Description of Embodiments

Preferred embodiments of the invention will now be explained in detail, with reference to the accompanying drawings as necessary. However, the present invention is not limited to the embodiments described below. Identical or corresponding parts in the drawings will be referred to by like reference numerals and will be explained only once. Also, the dimensional proportions depicted in the drawings are not necessarily limitative.

The anisotropic conductive particles of the invention have two independent features. The first feature is that the conductive fine particles are dispersed in an organic insulating material. The second feature is that the resistance after 50% flattening from the particle diameter, upon application of pressure to the anisotropic conductive particles, is no greater than 1/100 of the resistance of the anisotropic conductive particles before application of pressure.

The material, material quality, composition and production method are not particularly restricted, so long as the resistance after 50% flattening from the particle diameter, upon application of pressure to the anisotropic conductive particles, is no greater than 1/100 of the resistance of the anisotropic conductive particles before application of pressure, according to this second feature. This value is appropriately selected according to the degree of definition of the connecting circuit when the anisotropic conductive particles are to be used as a circuit connecting material, but it is more preferably no greater than 1/1000, especially preferably no greater than 1/10,000 and most preferably no greater than 1/100,000, from the viewpoint of more adequately obtaining both conductivity between opposing circuits and insulation between adjacent circuits, in high-definition circuits.

The phrase "resistance after 50% flattening from the particle diameter" means the resistance in the pressing direction, when pressure is applied to the anisotropic conductive particles and the thickness in the pressing direction has been deformed to 50% based on the thickness before pressing. When the anisotropic conductive particles have non-spherical shapes as described hereunder, the pressing direction is the direction of minimum thickness.

Fig. 1 is a schematic cross-sectional view showing a preferred embodiment of anisotropic conductive particles of the invention. The anisotropic conductive particles 7 of this embodiment are composed of an organic insulating material 3 and conductive fine particles 2 dispersed in the organic insulating material 3.

The anisotropic conductive particles 7 may be obtained by using the organic insulating material 3 as a binder and dispersing therein a prescribed amount of the conductive fine particles 2. Examples for the organic insulating material 3 include styrene resins, acrylic resins, silicone resins, polyimides, polyurethanes, polyamideimides, polyesters and the like.

The organic insulating material 3 may also be an organic-inorganic complex insulator material.

The anisotropic conductive particles 7 can also be provided by particles composed mainly of compounds having planar molecular structures and conjugated π electron orbitals perpendicular thereto, such as aromatic liquid crystal compounds, aromatic polycyclic compounds, phthalocyanines, naphthalocyanines and high-molecular-weight derivatives of these compounds.

The anisotropic conductive particles 7 of the invention may be obtained, for example, by suspension polymerization or pearl polymerization, wherein the starting monomer for the organic insulating material 3 and a curing agent are dispersed in water, with dispersion of a prescribed amount of conductive fine particles 2 together therewith in the polymerization system.

They may also be obtained by curing a dispersion of the conductive fine particles 2 in the starting monomer for the organic insulating material 3 by heat or ultraviolet rays, and pulverizing and classifying the cured product to obtain particles of the desired size.

Alternatively, they may be obtained by dispersing the conductive fine particles 2 in the starting monomer for the organic insulating material 3, forming a film using a coating machine or the like, pulverizing the film obtained by reacting the monomer by heat, ultraviolet rays or the like, and obtaining particles of the desired size by classification.

In addition, they may be obtained by melting the organic insulating material 3 or dissolving it in a solvent, dispersing a prescribed amount of conductive fine particles 2 therein, forming a film using a coating machine or the like, pulverizing the film obtained by reacting the monomer by heat, ultraviolet rays or the like, and obtaining particles of the desired size by classification.

When the conductive fine particles 2 that are used are magnetic bodies, a magnetic field may be applied in the vertical direction during film formation using a magnet or the like, for orientation of the conductive fine particles 2 in the vertical direction.

The mean particle size of the anisotropic conductive particles 7 of the invention is preferably 0.5-30 µm. The mean particle size is appropriately selected according to the degree of definition of the connecting circuit when the anisotropic conductive particles are to be used as a circuit connecting material, but it is more preferably 1-20 µm, from the viewpoint of conductivity between opposing circuits and insulation between adjacent circuits, in high-definition circuits. When the state of connection between the opposing circuits is to be confirmed by the flatness of the anisotropic conductive particles 7, the mean particle size is most preferably 2-10 µm from the viewpoint of visibility, for observation carried out with a microscope.

The mean particle size of the anisotropic conductive particles 7 is obtained by measuring the particle sizes of the individual particles with a microscope and determining the average (of 100 measurements).

The organic insulating material 3 used for the invention is preferably a material having an insulation resistance of 1 × 10⁸ Ω/cm or greater as measured under conditions of 25°C, 70% RH. The insulation resistance may be measured using a common insulation resistance meter, for example.

The organic insulating material 3 may be, for example, an organic insulating material such as a styrene resin, acrylic resin, silicone resin, polyimide, polyurethane, polyamideimide or polyester, an organic-inorganic composite insulating material, or a copolymer of the foregoing. These materials have a proven record of use in the prior art as starting materials for circuit connecting materials, and may be suitably used. They may be used alone or in combinations of two or more.

A common electric conductor may be used in the material of the conductive fine particles 2 used for the invention. Examples of materials for the conductive fine particles 2 include carbon materials such as graphite, carbon nanotubes, mesophase carbon, amorphous carbon, carbon black, carbon fiber, fullerene and carbon nanohoms, and metal materials such as platinum, silver, copper and nickel. Of these, graphites such as graphite or carbon nanotubes are preferred from the viewpoint of economical production. On the other hand, precious metals such as gold, platinum, silver and copper are preferred because they have low resistivity and can yield low connection resistance in small amounts. These conductive fine particles 2 are also preferred because of their ready availability on market. Conductive fine particles 2 composed of silver are available, for example, under the 3000 Series or SP Series product name by Mitsui Mining & Smelting Co., Ltd. Conductive fine particles 2 composed of copper are available, for example, under the 1000Y Series, 1000N Series, MA-C Series, 1000YP Series, T Series or MF-SH Series product name by Mitsui Mining & Smelting Co., Ltd. Conductive fine particles 2 composed of platinum are available, for example, under the AY-1000 Series product name by Tanaka Holdings Co., Ltd. Conductive fine particles 2 composed of graphite are available, for example, under the AT Series product name by Oriental Sangyo Co., Ltd. Conductive fine particles 2 composed of carbon nanotubes are available, for example, under the Carbere product name by GSI Creos Corp., and the VGCF Series product name by Showa Denko K.K. Conductive fine particles 2 composed of carbon black are available, for example, under the #3000 Series product name by Mitsubishi Chemical Corp. Most other carbon materials are available from Mitsubishi Chemical Corp., Nippon Carbon Co., Ltd. or Hitachi Chemical Co., Ltd. These may be used alone or in combinations of two or more.

The conductive fine particles 2 that are used may have the surface layer coated with a different metal, or the surfaces of the resin fine particles may be coated with a metal or the like.

The conductive fine particles 2 used in the anisotropic conductive particles 7 of the invention can easily exhibit their function by dispersion at 20-300 parts by volume with respect to 100 parts by volume of the organic insulating material 3. The amount of the conductive fine particles 2 is more preferably 30-250 parts by volume and especially preferably 50-150 parts by volume. If the amount of conductive fine particles 2 is less than 20 parts by volume, the resistance of the flattened anisotropic conductive particles 7 will tend to be higher. If it exceeds 300 parts by volume, the resistance of the anisotropic conductive particles 7 before application of pressure will tend to be lowered, and the insulation between adjacent circuits upon circuit connection may be reduced as a result.

The shapes of the conductive fine particles 2 used for the invention are not particularly restricted, and for example, they may be amorphous (having an undefined shape, or consisting of a mixture of particles of various shapes), spherical, elliptical spherical, globular, scaly, flaky, tabular, needle-like, filamentous or bead-like. Conductive fine particles 2 with scaly or needle-like shapes have greater surface area for the same volume, compared to spherical particles, elliptical particles or globular particles, and are therefore preferred for obtaining the same effect with smaller usage amounts. These may be used alone or in combinations of two or more.

The mean particle size of the conductive fine particles 2 used for the invention is preferably 0.0002-0.6 times, more preferably 0.001-0.5 times and most preferably 0.01-0.5 times the mean particle size of the anisotropic conductive particles 7. If the mean particle size of the conductive fine particles 2 is less than 0.0002 times the mean particle size of the obtained anisotropic conductive particles 7, it may be difficult to lower the resistance of the anisotropic conductive particles 7 during pressing. If it is greater than 0.6 times, the conductive fine particles 2 will tend to fly off from the surfaces of the anisotropic conductive particles 7, thus tending to lower the resistance of the anisotropic conductive particles 7 before application of pressure and potentially lowering the insulation between adjacent circuits during circuit connection.

The maximum particle size of the conductive fine particles 2 is preferably no greater than 0.9 times and more preferably no greater than 0.8 times the mean particle size of the anisotropic conductive particles 7. If the maximum particle size of the conductive fine particles 2 is greater than 0.9 times the mean particle size of the obtained anisotropic conductive particles 7, the conductive fine particles 2 will tend to fly off from the surfaces of the anisotropic conductive particles 7, thus tending to lower the resistance of the anisotropic conductive particles 7 before application of pressure and potentially lowering the insulation between adjacent circuits during circuit connection.

When the shape of a conductive fine particle 2 is any shape other than spherical, the particle size of the conductive fine particle 2 is the diameter of the smallest sphere that circumscribes the conductive fine particle 2.

The mean particle size and maximum particle size of the conductive fine particles 2 are obtained by measuring the particle sizes of the individual particles with a microscope and determining the average (of 100 measurements).

According to the invention, conductive fine particles 2 with hydrophobic-treated surfaces may be used. Hydrophobic treatment of the surfaces of the conductive fine particles 2 is preferred as it can increase the bonding strength between the conductive fine particles 2 and the organic insulating material 3 of the anisotropic conductive particles 7. Also, when the anisotropic conductive particles 7 of the invention are produced by a method for producing particles from oil droplets in an aqueous layer, such as suspension polymerization or emulsion polymerization, the conductive fine particles 2 can be selectively added to the oil droplets, thereby increasing production yield.

The hydrophobic treatment may be, for example, coupling agent treatment, or surface treatment of the conductive fine particles 2 with a sulfur atom-containing organic compound or nitrogen atom-containing organic compound.

The coupling agent treatment may involve, for example, impregnating the conductive fine particles 2 with a solution comprising a prescribed amount of coupling agent dissolved in a solvent capable of dissolving the coupling agent. In this case, the coupling agent content in the solution is preferably 0.01 mass%-5 mass% and more preferably 0.1 mass%-1.0 mass% with respect to the entire solution.

The coupling agent used may be, for example, a silane-based coupling agent, aluminum-based coupling agent, titanium-based coupling agent or zirconium-based coupling agent, with silane-based coupling agents being preferred for use. The silane-based coupling agent is preferably one having a functional group such as epoxy, amino, mercapto, imidazole, vinyl or methacryl in the molecule. These may be used alone or in combinations of two or more.

The solvent used for preparation of such silane-based coupling agent solutions may be, for example, water, an alcohol or a ketone. A small amount of an acid such as acetic acid or hydrochloric acid, for example, may also be added to promote hydrolysis of the coupling agent.

The conductive fine particles 2 that have been treated with the silane-based coupling agent may be dried by natural drying, heat drying or vacuum drying, for example. Depending on the type of coupling agent used, the drying may be preceded by rinsing or ultrasonic cleaning.

Examples of the sulfur atom-containing organic compounds and the nitrogen atom-containing organic compounds include sulfur atom-containing compounds such as mercapto, sulfide and disulfide compounds, and compounds including one or more nitrogen atom-containing organic compounds that have groups such as -N=, -N=N- or -NH₂ in the molecule. These may be used in addition to an acidic solution, alkaline solution or coupling agent solution. They may also be used alone or in combinations of two or more.

Examples of the sulfur atom-containing organic compounds include aliphatic thiols represented by the following formula (I):

HS-(CH₂)ₙ-R (I)

(wherein n is an integer of 1-23, and R represents a monovalent organic group, hydrogen or a halogen atom),
thiazole derivatives (thiazole, 2-aminothiazole, 2-aminothiazole-4-carboxylic acid, aminothiophene, benzothiazole, 2-mercaptobenzothiazole, 2-aminobenzothiazole, 2-amino-4-methylbenzothiazole, 2-benzothiazolol, 2,3-dihydroimidazo[2,1-b]benzothiazole-6-amine, ethyl 2-(2-aminothiazol-4-yl)-2-hydroxyiminoacetate, 2-methylbenzothiazole, 2-phenylbenzothiazole, 2-amino-4-methylthiazole and the like), thiadiazole derivatives (1,2,3-thiadiazole, 1,2,4-thiadiazole, 1,2,5-thiadiazole, 1,3,4-thiadiazole, 2-amino-5-ethyl-1,3,4-thiadiazole, 5-amino-1,3,4-thiadiazole-2-thiol, 2,5-mercapto-1,3,4-thiadiazole, 3-methylmercapto-5-mercapto-1,2,4-thiadiazole, 2-amino-1,3,4-thiadiazole, 2-(ethylamino)-1,3,4-thiadiazole, 2-amino-5-ethylthio-1,3,4-thiadiazole and the like), mercaptobenzoic acid, mercaptonaphthol, mercaptophenol, 4-mercaptobiphenyl, mercaptoacetic acid, mercaptosuccinic acid, 3-mercaptopropionic acid, thiouracil, 3-thiourazole, 2-thiouramil, 4-thiouramil, 2-mercaptoquinoline, thioformic acid, 1-thiocoumarin, thiocoumothiazone, thiocresol, thiosalicylic acid, thiocyanuric acid, thionaphthol, thiotolene, thionaphthene, thionaphthenecarboxylic acid, thionaphthenequinone, thiobarbituric acid, thiohydroquinone, thiophenol, thiophene, thiophthalide, thiophthene, thiolthionecarbonic acid, thiolutidone, thiolhistidine, 3-carboxypropyl disulfide, 2-hydroxyethyl disulfide, 2-aminopropionic acid, dithiodiglycolic acid, D-cysteine, di-t-butyl disulfide, thiocyan and thiocyanic acid. These may be used alone or in combinations of two or more.

In formula (I) which represents an aliphatic thiol, R is preferably a monovalent organic group such as amino, amide, carboxyl, carbonyl or hydroxyl, for example, but there is no limitation to these, and it may be, for example, a C1-18 alkyl, C1-8 alkoxy, acyloxy or haloalkyl group, a halogen atom, hydrogen, thioalkyl, thiol, optionally substituted phenyl, biphenyl, naphthyl or a heterocyclic ring. The monovalent organic group may have a single amino group, amide, carboxyl or hydroxyl group, but it preferably has more than one and more preferably more than two such groups. The other monovalent organic groups mentioned above may be optionally substituted with alkyl or the like.

In formula (I) representing an aliphatic thiol group, n is an integer of 1-23, more preferably an integer of 4-15 and most preferably an integer of 6-12.

Examples of the nitrogen atom-containing organic compounds include triazole derivatives (1H-1,2,3-triazole, 2H-1,2,3-triazole, 1H-1,2,4-triazole, 4H-1,2,4-triazole, benzotriazole, 1-aminobenzotriazole, 3-amino-5-mercapto-1,2,4-triazole, 3-amino-1H-1,2,4-triazole, 3,5-diamino-1,2,4-triazole, 3-oxy-1,2,4-triazole, aminourazole and the like), tetrazole derivatives (tetrazolyl, tetrazolylhydrazine, 1H-1,2,3,4-tetrazole, 2H-1,2,3,4-tetrazole, 5-amino-1H-tetrazole, 1-ethyl-1,4-dihydroxy-5H-tetrazol-5-one, 5-mercapto-1-methyltetrazole, tetrazolemercaptane and the like), oxazole derivatives (oxazole, oxazolyl, oxazoline, benzooxazole, 3-amino-5-methylisooxazole, 2-mercaptobenzooxazole, 2-aminooxazoline, 2-aminobenzooxazole and the like), oxadiazole derivatives (1,2,3-oxadiazole, 1,2,4-oxadiazole, 1,2,5-oxadiazole, 1,3,4-oxadiazole, 1,2,4-oxadiazolone-5, 1,3,4-oxadiazolone-5 and the like), oxatriazole derivatives (1,2,3,4-oxatriazole, 1,2,3,5-oxatriazole and the like), purine derivatives (purine, 2-amino-6-hydroxy-8-mercaptopurine, 2-amino-6-methylmercaptopurine, 2-mercaptoadenine, mercaptohypoxanthine, mercaptopurine, uric acid, guanine, adenine, xanthine, theophylline, theobromine, caffeine and the like), imidazole derivatives (imidazole, benzimidazole, 2-mercaptobenzimidazole, 4-amino-5-imidazolecarboxylic acid amide, histidine and the like), indazole derivatives (indazole, 3-indazolone, indazolol and the like), pyridine derivatives (2-mercaptopyridine, aminopyridine and the like), pyrimidine derivatives (2-mercaptopyrimidine, 2-aminopyrimidine, 4-aminopyrimidine, 2-amino-4,6-dihydroxypyrimidine, 4-amino-6-hydroxy-2-mercaptopyrimidine, 2-amino-4-hydroxy-6-methylpyrimidine, 4-amino-6-hydroxy-2-methylpyrimidine, 4-amino-6-hydroxypyrazolo[3,4-d]pyrimidine, 4-amino-6-mercaptopyrazolo[3,4-d]pyrimidine, 2-hydroxypyrimidine, 4-mercapto-1H-pyrazolo[3,4-d]pyrimidine, 4-amino-2,6-dihydroxypyrimidine, 2,4-diamino-6-hydroxypyrimidine, 2,4,6-triaminopyrimidine and the like), thiourea derivatives (thiourea, ethylenethiourea, 2-thiobarbituric acid and the like), amino acids (glycine, alanine, tryptophan, proline, oxyproline and the like), 1,3,4-thiooxadiazolone-5, thiocoumazone, 2-thiocoumarin, thiosaccharin, thiohydantoin, thiopyrine, γ-thiopyrine, guanadine, guanazole, guanamine, oxazine, oxadiazine, melamine, 2,4,6-triaminophenol, triaminobenzene, aminoindole, aminoquinoline, aminothiophenol and aminopyrazole. These may be used alone or in combinations of two or more.

These anisotropic conductive particles 7 falling within the scope of the invention may be used alone or in combinations of two or more, depending on the purpose, and they may also be used in combination with anisotropic conductive particles or conductive particles that are outside the scope of the invention.

### Examples

Preferred examples of the invention will now be described, with the understanding that these examples are in no way limitative on the invention.

### [Example 1]

### <Production of conductive fine particles>

Scaly silver powder 1 having a particle size distribution of 0.005-10 µm was obtained by a chemical reduction method. The obtained silver powder 1 was classified to obtain scaly silver powder 2 having a mean particle size of 0.25 µm and a maximum particle size of 0.4 µm.

### <Production of anisotropic conductive particles>

The starting monomer for an organic insulating material was prepared by mixing 60 parts by mass of tetramethylolmethane triacrylate, 20 parts by mass of divinylbenzene and 20 parts by mass of acrylonitrile. Also, silver powder 2 was added at 120 parts by volume to 100 parts by volume of the starting monomer for the organic insulating material, and a bead mill was used for dispersion of the silver powder for 48 hours. After mixing 2 parts by mass of benzoyl peroxide with the silver powder-dispersed composition, the mixture was loaded into 850 parts by mass of a 3 mass% polyvinyl alcohol aqueous solution and thoroughly stirred, after which it was suspended with a homogenizer until the polymerizable monomer droplets formed fine particulates with particle sizes of approximately 0.4-33 µm, to obtain a suspension. The obtained suspension was transferred to a 2 liter separable flask equipped with a thermometer, stirrer and reflux condenser, and the temperature was raised to 85°C while stirring in a nitrogen atmosphere for 7 hours of polymerization reaction, after which the temperature was raised to 90°C and maintained for 3 hours to complete the polymerization reaction. The polymerization reaction solution was then cooled, and the produced particles were filtered out and thoroughly rinsed with water and dried to obtain anisotropic conductive particles having a particle size of 0.4-33 µm. The obtained anisotropic conductive particles were classified to obtain anisotropic conductive particles 1 with a mean particle size of 5.55 µm comprising silver fine particles.

### <Measurement of anisotropic conductive particle resistance>

A microcompression tester (Model PCT-200 by Shimadzu Corp.) was used to join gold wires to both the indenter and stainless steel table of the microcompression tester, to allow measurement of the resistance between the indenter and stainless steel table, and the resistance of the anisotropic conductive particles 1 before application of pressure and the resistance after 50% flattening were measured (100 measurements), giving the results shown in Table 1. The results in Table 1 are the average values for the resistance measured for 100 anisotropic conductive particles 1.

### [Example 2]

The silver powder 2 prepared in Example 1 was impregnated with a solution of 3 parts by mass of N-(2-aminoethyl)-3-aminopropyltrimethoxysilane in 100 parts by mass of methyl ethyl ketone, and stirring was carried out for one day and night for hydrophobic treatment of the silver powder surface. Anisotropic conductive particles 2 were obtained in the same manner as Example 1, except for using this silver powder with a hydrophobic-treated surface. The resistance of the anisotropic conductive particles 2 before application of pressure and the resistance after 50% flattening were measured by the same method as Example 1, giving the results shown in Table 1.

### [Example 3]

The anisotropic conductive particles prepared in Example 1 were classified to obtain anisotropic conductive particles 3 having a mean particle size of 0.5 µm. The resistance of the anisotropic conductive particles 3 before application of pressure and the resistance after 50% flattening were measured by the same method as Example 1, giving the results shown in Table 1.

### [Example 4]

The anisotropic conductive particles prepared in Example 1 were classified to obtain anisotropic conductive particles 4 having a mean particle size of 30 µm. The resistance of the anisotropic conductive particles 4 before application of pressure and the resistance after 50% flattening were measured by the same method as Example 1, giving the results shown in Table 1.

### [Example 5]

Anisotropic conductive particles 5 were obtained in the same manner as Example 1, except that the content of the silver powder 2 used in Example 1 was 20 parts by volume. The resistance of the anisotropic conductive particles 5 before application of pressure and the resistance after 50% flattening were measured by the same method as Example 1, giving the results shown in Table 1.

### [Example 6]

Anisotropic conductive particles 6 were obtained in the same manner as Example 1, except that the content of the silver powder 2 used in Example 1 was 300 parts by volume. The resistance of the anisotropic conductive particles 6 before application of pressure and the resistance after 50% flattening were measured by the same method as Example 1, giving the results shown in Table 1.

### [Example 7]

The silver powder 1 used in Example 1 was classified to obtain scaly silver powder 3 having a mean particle size of 0.01 µm and a maximum particle size of 0.03 µm. Anisotropic conductive particles 7 were obtained in the same manner as Example 1, except that this silver powder 3 was used. The resistance of the anisotropic conductive particles 7 before application of pressure and the resistance after 50% flattening were measured by the same method as Example 1, giving the results shown in Table 1.

### [Example 8]

The silver powder 1 used in Example 1 was classified to obtain scaly silver powder 4 having a mean particle size of 3.3 µm and a maximum particle size of 4.95 µm. Anisotropic conductive particles 8 were obtained in the same manner as Example 1, except that this silver powder 4 was used. The resistance of the anisotropic conductive particles 8 before application of pressure and the resistance after 50% flattening were measured by the same method as Example 1, giving the results shown in Table 1.

### [Example 9]

Anisotropic conductive particles 9 were obtained in the same manner as Example 1, except that amorphous graphite having a mean particle size of 3 µm and a maximum particle size of 4 µm was used in the conductive fine particles. The resistance of the anisotropic conductive particles 9 before application of pressure and the resistance after 50% flattening were measured by the same method as Example 1, giving the results shown in Table 1.

### [Example 10]

Anisotropic conductive particles 10 were obtained in the same manner as Example 1, except that needle-like graphite having a mean particle size of 3 µm and a maximum particle size of 4 µm was used in the conductive fine particles. The resistance of the anisotropic conductive particles 10 before application of pressure and the resistance after 50% flattening were measured by the same method as Example 1, giving the results shown in Table 1.

### [Example 11]

Anisotropic conductive particles 11 were obtained in the same manner as Example 1, except that spherical gold having a mean particle size of 1 µm and a maximum particle size of 2 µm was used in the conductive fine particles. The resistance of the anisotropic conductive particles 11 before application of pressure and the resistance after 50% flattening were measured by the same method as Example 1, giving the results shown in Table 1.

### [Example 12]

After adding 120 parts by volume of silver powder 2 to 100 parts by volume of a silicone resin (KR-242A, product of Shin-Etsu Chemical Co., Ltd.), a bead mill was used for dispersion of the silver powder for 48 hours. There was further added 1 part by mass of the polymerization catalyst CAT-AC (product of Shin-Etsu Chemical Co., Ltd.) to 100 parts by mass of the silicone resin, and the mixture was stirred for 10 minutes. The obtained conductive fine particle-dispersing silicone resin was coated onto a PET film using a coating apparatus and dried with hot air at 120°C for 1 hour, to obtain a film-like conductive fine particle-dispersing silicone resin with a thickness of 50 µm. The obtained film-like conductive fine particle-dispersing silicone resin was pulverized and then classified to obtain anisotropic conductive particles 12 having a mean particle size of 5 µm. The resistance of the anisotropic conductive particles 12 before application of pressure and the resistance after 50% flattening were measured by the same method as Example 1, giving the results shown in Table 1.

### [Example 13]

Anisotropic conductive particles 13 were obtained in the same manner as Example 1, except that the content of the silver powder 2 used in Example 1 was 10 parts by volume. The resistance of the anisotropic conductive particles 13 before application of pressure and the resistance after 50% flattening were measured by the same method as Example 1, giving the results shown in Table 1.

### [Example 14]

Anisotropic conductive particles 14 were obtained in the same manner as Example 1, except that the content of the silver powder 2 used in Example 1 was 400 parts by volume. The resistance of the anisotropic conductive particles 14 before application of pressure and the resistance after 50% flattening were measured by the same method as Example 1, giving the results shown in Table 1.

### [Example 15]

The silver powder 1 used in Example 1 was classified to obtain scaly silver powder 5 having a mean particle size of 3.9 µm and a maximum particle size of 5.5 µm. Anisotropic conductive particles 15 were obtained in the same manner as Example 1, except that this silver powder 5 was used. The resistance of the anisotropic conductive particles 15 before application of pressure and the resistance after 50% flattening were measured by the same method as Example 1, giving the results shown in Table 1.

### [Comparative Example 1 (Conductive particles)]

Conductive particles, which were resin particles coated with nickel and gold (product name: Micropearl AU, by Sekisui Chemical Co., Ltd.) were used as the conductive particles for Comparative Example 1. The resistance of the conductive particles before application of pressure and the resistance after 50% flattening were measured by the same method as Example 1, giving the results shown in Table 1.

### [Comparative Example 2 (Insulating particle-coated conductive particles)]

### <Production of insulating particles>

In a 1000 mL-volume separable flask on which a 4-necked separable cover, stirring blade, three-way cock, condenser tube and temperature probe were mounted, a monomer composition comprising 100 mmol of methyl methacrylate, 1 mmol of N,N,N-trimethyl-N-2-methacryloyloxyethylammonium chloride and 1 mmol of 2,2'-azobis(2-amidinopropane) dihydrochloride was added to distilled water to a solid content of 5 mass%, and the mixture was stirred at 200 rpm, for polymerization under a nitrogen atmosphere at 70°C for 24 hours. Upon completion of the reaction, the mixture was freeze-dried to obtain insulating particles with a mean particle size of 220 nm, having ammonium groups on the surface.

### <Production of metal surface particles>

Core particles composed of tetramethylolmethane tetraacrylate/divinylbenzene copolymer with a mean particle size of 5 µm were subjected to degreasing, sensitizing and activating to produce Pd nuclei on the resin surface, to form catalyst nuclei for electroless plating. Next, the particles with catalyst nuclei were dipped in a prepared, heated electroless Ni plating bath according to a prescribed method to form a Ni plating layer. The nickel layer surface was then subjected to electroless substitution gold plating to obtain metal surface particles. The Ni plating thickness on the obtained metal surface particles was 90 nm, and the gold plating thickness was 30 nm.

### <Production of insulating particle-coated conductive particles>

The insulating particles were dispersed in distilled water under ultrasonic irradiation, to obtain a 10 mass% aqueous dispersion of insulating particles. After dispersing 10 g of the metal surface particles in 500 mL of distilled water, 4 g of the aqueous dispersion of insulating particles was added and the mixture was stirred at room temperature (25°C) for 6 hours. After filtration with a 3 µm mesh filter, it was further rinsed with methanol and dried to obtain insulating particle-coated conductive particles. The resistance of the obtained insulating particle-coated conductive particles before application of pressure and the resistance after 50% flattening were measured by the same method as Example 1, giving the results shown in Table 1.

### [Comparative Example 3 (Insulating resin-coated conductive particles)]

The metal surface particles of Comparative Example 2 were added to and stirred with a 1 mass% dimethylformamide (DMF) solution of PARAPRENE P-25M (thermoplastic polyurethane resin, softening point: 130°C, trade name of Nippon Elastran Co., Ltd.). Next, the obtained dispersion was subjected to spray-drying at 100°C for 10 minutes using a spray drier (Model GA-32 by Yamato Scientific Co., Ltd.), to obtain insulating resin-coated conductive particles. The average thickness of the covering layer comprising the insulating resin was approximately 1 µm according to cross-sectional observation with an electron microscope (SEM). The resistance of the obtained insulating resin-coated conductive particles before application of pressure and the resistance after 50% flattening were measured by the same method as Example 1, giving the results shown in Table 1.

**[Table 1]**

| | Non-deformed resistance (Ω) | 50% Flattened resistance (Ω) |
|---|---|---|
| Example 1 | >10 × 10⁶ | 19.4 |
| Example 2 | >10 × 10⁶ | 20.3 |
| Example 3 | >10 × 10⁶ | 25.4 |
| Example 4 | >10 × 10⁶ | 17.4 |
| Example 5 | >10 × 10⁶ | 343 |
| Example 6 | >10 × 10⁶ | 12.3 |
| Example 7 | >10 × 10⁶ | 864 |
| Example 8 | >10 × 10⁶ | 16.4 |
| Example 9 | >10 × 10⁶ | 33.3 |
| Example 10 | >10 × 10⁶ | 42.6 |
| Example 11 | >10 × 10⁶ | 10.9 |
| Example 12 | >10 × 10⁶ | 17.8 |
| Example 13 | >10 × 10⁶ | 1.70 × 10⁵ |
| Example 14 | 1033 | 11.6 |
| Example 15 | 33.5 | 9.2 |
| Comp. Ex. 1 | 10.9 | 9.4 |
| Comp. Ex. 2 | 35.4 | 28.3 |
| Comp. Ex. 3 | >10 × 10⁶ | >10 × 10⁶ |

The anisotropic conductive particles obtained in Examples 1-12 all had resistance after 50% flattening from the particle diameter, upon application of pressure, of no greater than 1/100 of the resistance of the anisotropic conductive particles before application of pressure.

In Example 13, the amount of conductive fine particles in the particles was small and therefore even with 50% flattening, the 50% flattened resistance did not fall below 1/100 of the non-deformed particles, although it was reduced compared to Comparative Examples 1 and 2.

In Example 14, the amount of conductive fine particles was too great and the resistance of the non-deformed particles was low, although the 50% flattened resistance was below 1/100 compared to the non-deformed particles.

In Example 15, some of the conductive fine particles flew off from the anisotropic conductive particles, thereby lowering the non-deformed resistance, although the 50% flattened resistance was below 1/100.

Comparative Example 1 had a metal plating on the surface and therefore had virtually no difference between the non-deformed resistance and the 50% flattened resistance, which were both low resistance values. The reduction of the 50% flattened resistance to about 10% of the non-deformed resistance is attributed to the wider contact area between the indenter and stainless steel table of the microcompression tester due to flattening.

In Comparative Example 2, the indenter of the microcompression tester passed into the gaps between the insulating particles attached to the surfaces of the Ni plating particles, directly contacting with the plating layer, and there was virtually no difference between the non-deformed resistance and 50% flattened resistance, with low resistance values for both. The reduction of the 50% flattened resistance to about 20% of the non-deformed resistance is attributed to the wider contact area between the indenter and stainless steel table of the microcompression tester due to flattening.

In Comparative Example 3, the plating layer was uniformly covered by the insulating material, and therefore no change in resistance occurred even with 50% flattening of the particles.

In Examples 13 to 15, the change in resistance with 50% flattening was to below 1/100 of the non-deformed resistance, and since a larger change in resistance was obtained than in Comparative Examples 1 to 3, these can be provided for practical use depending on the purpose.

### Industrial Applicability

As explained above, it is possible according to the invention to provide anisotropic conductive particles that, when used in a circuit connecting material, can both ensure insulation between adjacent circuits and ensure conductivity between opposing circuits.

### Explanation of Symbols

2: Conductive fine particle, 3: organic insulating material, 7: anisotropic conductive particle.

## Claims

1. Anisotropic conductive particles comprising conductive fine particles dispersed in an organic insulating material.

2. Anisotropic conductive particles wherein the resistance after 50% flattening from the particle diameter, upon application of pressure to the anisotropic conductive particles, is no greater than 1/100 of the resistance of the anisotropic conductive particles before application of the pressure.

3. The anisotropic conductive particles according to claim 2, comprising conductive fine particles dispersed in an organic insulating material.

4. The anisotropic conductive particles according to claim 1 or 3, which comprise 20-300 parts by volume of the conductive fine particles dispersed in 100 parts by volume of the organic insulating material.

5. The anisotropic conductive particles according to any one of claims 1, 3 and 4, wherein the mean particle size of the conductive fine particles is 0.0002-0.6 times the mean particle size of the anisotropic conductive particles.

6. The anisotropic conductive particles according to any one of claims 1 and 3-5, wherein the maximum particle size of the conductive fine particles is no greater than 0.9 times the mean particle size of the anisotropic conductive particles.

7. The anisotropic conductive particles according to any one of claims 1 and 3-6, wherein the conductive fine particles are particles composed of a carbon material.

8. The anisotropic conductive particles according to claim 7, wherein the carbon material is graphite.

9. The anisotropic conductive particles according to claim 7, wherein the carbon material is carbon nanotubes.

10. The anisotropic conductive particles according to any one of claims 1 and 3-6, wherein the conductive fine particles are particles composed of a metal material.

11. The anisotropic conductive particles according to claim 10, wherein the metal material is silver.

12. The anisotropic conductive particles according to claim 10, wherein the metal material is gold.

13. The anisotropic conductive particles according to any one of claims 1, 3-7 and 10, wherein the shapes of the conductive fine particles are scaly.

14. The anisotropic conductive particles according to any one of claims 1, 3-7 and 10, wherein the shapes of the conductive fine particles are needle-like.

15. The anisotropic conductive particles according to any one of claims 1 and 3-14, wherein the conductive fine particles have hydrophobic-treated surfaces.

16. The anisotropic conductive particles according to any one of claims 1 to 15, which have a mean particle size of 0.5-30 µm.
